# EUROPEAN PATENT APPLICATION

(11) **EP 4 709 072 A1**
(43) Date of publication of application: **11.03.2026**
(21) Application number: 25198263.3
(22) Date of filing: 26.08.2025
(51) Int. Cl.: H05K 7/20

(54) **LIQUID COOLING SYSTEM AND METHOD FOR ABNORMAL CONDITION DETECTION**

(30) Priority: 27.08.2024 US 202463687477 P; 22.08.2025 US 202519307430
(71) Applicant: Vertiv Corporation, Westerville, OH 43082 (US)
(72) Inventor: Keller, Matthew Griffith, Westerville, 43082 (US); Menoche, John Paul, Westerville, 43082 (US); Jones, Michael Bruce, Westerville, 43082 (US); Khan, Aman, Westerville, 43082 (US); Wong, Kah Koi, Westerville, 43082 (US)
(74) Representative: Cousens, Nico

(57) **Abstract**

A liquid cooling system is disclosed. The liquid cooling system comprises an in-rack manifold configured to circulate coolant to in-rack electronic components. The in-rack manifold comprises a plurality of sensors positioned within the in-rack manifold. The plurality of sensors are configured to: measure a plurality of parameters associated with the coolant; and generate a plurality of signals indicative of the plurality of parameters. The liquid cooling system further comprises a control unit. The control unit is configured to: receive the plurality of signals from the plurality of sensors; and detect, based on the plurality of signals, an abnormal condition within the liquid cooling system.

## Description

This patent application claims the benefit of and priority to U.S. Provisional Patent Application Serial No. 63/687,477 filed August 27, 2024.

### TECHNICAL FIELD

The present disclosure relates to liquid cooling systems for electronic equipment, particularly in data centers and other high-performance computing environments.

### BACKGROUND

Direct to chip servers and supporting cooling loop infrastructure have several potential failure points when circulating coolant to in-rack equipment. The cooling loop infrastructure includes components involved in circulating the coolant, such as the pump, piping, and heat exchangers, and circulates liquid coolant through channels or cold plates that come into direct contact with hot components, such as computer and graphics processing units. Failures within the cooling loop infrastructure can include leaks, blockages, or equipment failures.

A solution is needed for detecting such issues and communicating the issues to other components of the system.

### SUMMARY

This disclosure relates generally to in-rack cooling systems.

An aspect of the disclosed embodiments includes a liquid cooling system. The liquid cooling system comprises an in-rack manifold configured to circulate coolant to in-rack electronic components. The in-rack manifold comprises a plurality of sensors positioned within the in-rack manifold. The plurality of sensors are configured to: measure a plurality of parameters associated with the coolant; and generate a plurality of signals indicative of the plurality of parameters. The liquid cooling system further comprises a control unit configured to: receive the plurality of signals from the plurality of sensors; and detect, based on the plurality of signals, an abnormal condition within the liquid cooling system.

Another aspect of the disclosed embodiments includes a method that includes: measuring a plurality of parameters associated with a liquid coolant of a liquid coolant system; generating a plurality of signals indicative of the plurality of parameters; receiving the plurality of signals; and detecting, based on the plurality of signals, an abnormal condition within the liquid cooling system.

Another aspect of the disclosed embodiments includes an apparatus that includes a computing device configured to: measure, using a plurality of sensors associated with an in-rack manifold, a plurality of parameters associated with a liquid coolant of a liquid cooling system; generate a plurality of signals indicative of the plurality of parameters; and detect, based on the plurality of signals, an abnormal condition within the liquid cooling system.

These and other aspects of the present disclosure are disclosed in the following detailed description of the embodiments, the appended claims, and the accompanying figures.

### BRIEF DESCRIPTION OF THE DRAWINGS

The disclosure is best understood from the following detailed description when read in conjunction with the accompanying drawings. It is emphasized that, according to common practice, the various features of the drawings are not to scale. On the contrary, the dimensions of the various features are arbitrarily expanded or reduced for clarity.
FIG. 1 illustrates a liquid cooling system configured to distribute coolant to in-rack electronic components while monitoring and controlling coolant flow through the liquid cooling system, according to the principles of the present disclosure.
FIG. 2 illustrates an exemplary embodiment of sensors used in the liquid cooling system, according to the principles of the present disclosure.
FIG. 3 depicts a flowchart of a method for detection of an abnormal condition within an in-rack liquid cooling system, according to the principles of the present disclosure.
FIG. 4 depicts a use case of the liquid cooling system for detecting a rack leak, according to the principles of the present disclosure.
FIG. 5 depicts a use case of the liquid cooling system for detecting a server leak, according to the principles of the present disclosure.
FIG. 6 depicts a use case of the liquid cooling system for detecting a pressure or flow drop, according to the principles of the present disclosure.
FIG. 7 depicts a use case of the liquid cooling system for detecting a fluid quality issue, according to the principles of the present disclosure.
FIG. 8 is a block diagram of an example computing device that may be used to implement embodiments, according to the principles of the present disclosure.

Those skilled in the art will appreciate and understand that, according to common practice, various features of the drawings discussed below are not necessarily drawn to scale, and that dimensions of various features and elements of the drawings may be expanded or reduced to more clearly illustrate the embodiments of the present disclosure described herein.

### DETAILED DESCRIPTION

The following discussion is directed to various embodiments of the disclosure. Although one or more of these embodiments may be preferred, the embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment.

The present specification and accompanying drawings disclose one or more embodiments that incorporate the features of the present disclosure. The scope of the present disclosure is not limited to the disclosed embodiments. The disclosed embodiments merely exemplify the present disclosure, and modified versions of the disclosed embodiments are also encompassed by the present disclosure. Embodiments of the present disclosure are defined by the claims appended hereto.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In the discussion, unless otherwise stated, adjectives such as "substantially," "approximately," and "about" modifying a condition or relationship characteristic of a feature or features of an embodiment of the disclosure, are understood to mean that the condition or characteristic is defined to be within tolerances that are acceptable for operation of the embodiment for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same embodiment or implementation unless described as such.

Numerous exemplary embodiments are described as follows. It is noted that any section/subsection headings provided herein are not intended to be limiting. Embodiments are described throughout this document, and any type of embodiment may be included under any section/subsection. Furthermore, embodiments disclosed in any section/subsection may be combined with any other embodiments described in the same section/subsection and/or a different section/subsection in any manner.

Direct to chip servers and supporting cooling loop infrastructure have several potential failure points when circulating coolant to in-rack equipment. The cooling loop infrastructure includes components involved in circulating the coolant, such as the pump, piping, and heat exchangers, and circulates liquid coolant through channels or cold plates that come into direct contact with hot components, such as computer and graphics processing units. Failures within the cooling loop infrastructure can include leaks, blockages, or equipment failures. A solution is needed for detecting such issues and communicating the issues to other components of the system.

Embodiments disclosed herein are directed to a liquid cooling system configured to address the issues discussed above. For example, the liquid cooling system may include an in-rack manifold configured to circulate coolant to in-rack electronic components. The in-rack manifold may include a plurality of sensors positioned within the in-rack manifold. The plurality of sensors may be configured to measure a plurality of parameters associated with the coolant and generate a plurality of signals indicative of the plurality of parameters. The liquid cooling system may further comprise a control unit. The control unit may be configured to receive the plurality of signals from the plurality of sensors and detect, based on the plurality of signals, an abnormal condition within the liquid cooling system.

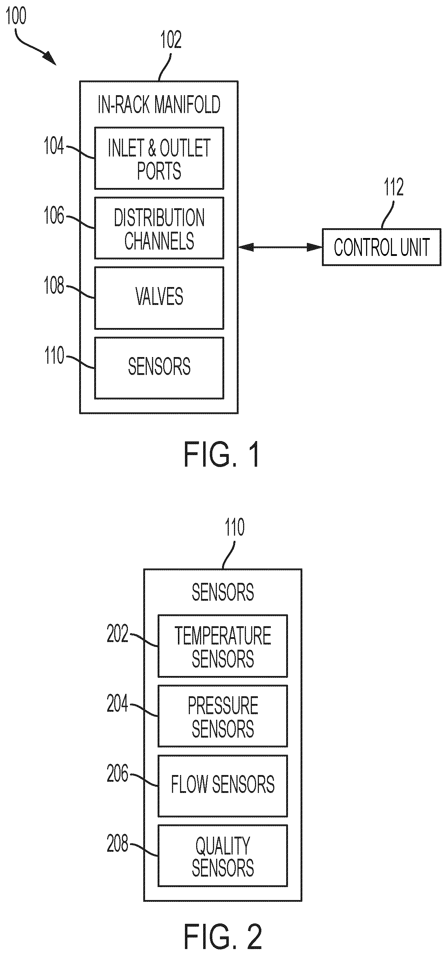

To help further illustrate the foregoing, FIG. 1 illustrates an exemplary embodiment of a liquid cooling system configured to distribute coolant to in-rack electronic components while monitoring and controlling coolant flow through the liquid cooling system. In FIG. 1, a liquid cooling system 100 includes an in-rack manifold 102 and a control unit 112. Also in FIG. 1, the in-rack manifold 102 includes an inlet and outlet ports 104, distribution channels 106, valves 108, and sensors 110.

The inlet and outlet ports 104 are configured to receive coolant into the in-rack manifold 102 to distribute it to the in-rack electronic components and enable coolant to exit the in-rack manifold 102 for recirculation. The distribution channels 106 comprise the internal pathways within the in-rack manifold 102 and are configured to direct flow of coolant from the inlet ports to the outlet ports of the inlet and outlet ports 104. The valves 108 (e.g., solenoid valves) are configured to enable the liquid cooling system 100 to control the flow of coolant. For example, the valves can be opened or closed to manage the distribution of coolant to the in-rack electronic components. The sensors 110 are configured to monitor parameters of the coolant, such as temperature, pressure, rate of coolant flow, and quality of the coolant. In some embodiments, the coolant may be conductive (e.g., water based), non-conductive liquid or refrigerant (e.g., A2L).

The control unit 112 is configured to monitor signals from the sensors 110, detect any abnormal conditions based on the signals, such as leaks or temperature fluctuations, and manage operation of the valves 108 and other components (e.g., heat exchangers, pumps, fan units, etc.) to maintain proper and safe operation of the liquid cooling system 100. The control unit 112 is further configured to initiate alarms and shut down affected parts of the liquid cooling system 100 in response to detecting an abnormal condition. Abnormal conditions as used herein refers to any deviation from expected or predefined operational parameters that could indicate a problem or potential failure within the liquid cooling system 100. These conditions may be outside a normal range of values for variables such as temperature, pressure, coolant flow rate, or coolant quality, and may signal issues like leaks, blockages, equipment malfunctions, or insufficient cooling.

For example, the control unit 112 may receive real-time data from the sensors 110 placed at strategic points within the in-rack manifold 102 (e.g., close to sensitive electronic components). The sensors 110 may measure parameters like temperature, pressure, coolant flow rate, and coolant quality (e.g., pH levels or contamination).

The control unit 112 is further configured to process the data received from the sensors 110 to assess the current state of the liquid cooling system 100. For example, the control unit 112 may compare the sensor data against predefined thresholds or expected values. If the sensor data is within an acceptable range, the control unit 112 may allow the liquid cooling system 100 to continue to operate as normal. If any sensor data falls outside of the predefined safe ranges, the control unit 112 may flag this as an abnormal condition.

Additionally, the control unit 112, upon detecting an abnormal condition, is configured to initiate various responses, such as activating alarms to alert operators of the issue, shutting down affected parts of the liquid cooling system 100 (e.g., isolating affected sections where a leak is detected), adjusting the operation of components (e.g., like pumps, valves, and fans to correct the issue), and communicating with other systems like the rack Power Distribution Unit (rPDU), Cooling Distribution Unit (CDU), or Building Management System (BMS) to coordinate a broader response (e.g., such as shutting down power to protect electronic equipment).

As described, the in-rack manifold 102 houses various sensors that monitor parameters of the coolant. FIG. 2 illustrates an exemplary embodiment of the sensors 110 in FIG. 1. As depicted in FIG. 2, the sensors 110 includes temperature sensors 202, pressure sensors 204, flow sensors 206, and quality sensors 208. The temperature sensors 202 are configured to measure the temperature of the coolant as it flows through the in-rack manifold 102. The pressure sensors 204 are configured to detect pressure levels within the in-rack manifold 102. The flow sensors 206 are configured to measure the rate of coolant flow through the manifold, helping to detect leaks or blockages. The quality sensors 208 are configured to assess the quality or composition of the coolant, detecting any contamination or degradation.

For example, temperature sensors 202 may be placed at various points within the in-rack manifold 102 close to critical electronic equipment. If a temperature sensor of the temperature sensors 202 detects that the coolant temperature is higher than expected, it may indicate insufficient cooling. In this example, the control unit 112 may respond by opening additional valves or triggering an alarm. Moreover, if the coolant temperature suddenly drops below normal levels, it could indicate a leak. The control unit 112 could respond by activating shutoff valves to isolate the leak.

Additionally, based on data from the pressure sensors 204, a sudden drop in pressure could be detected, which may indicate a coolant leak or a pump failure. The control unit 112 may respond by shutting down the affected section or activating backup pumps. To help further illustrate, an unexpected increase in pressure may indicate a blockage. The control unit 112 may respond by adjusting valve positions to relieve pressure.

As another example, based on data from the flow sensors 206, if the control unit 112 detects that the flow rate suddenly drops, it could indicate a blockage. The control unit 112 may respond by opening additional flow paths to compensate. Additionally, if a flow sensor detects no movement of coolant, it could signal a failure, such as a large leak, and the control unit 112 could immediately shut down the liquid cooling system 100.

Finally, based on data from the quality sensors 208, if the control unit 112 detects the contaminants, it could indicate that the coolant needs to be replaced or that there is a contamination source within the liquid cooling system 100. In this instance, the control unit 112 could initiate a controlled shutdown of the liquid cooling system 100 for maintenance.

In some embodiments, when an abnormal condition is detected, the liquid cooling system 100 is configured to respond immediately. The control unit 112 may enact a series of alarms or direct actions, such as shutting off supply and return values to isolate the affected part of the liquid cooling system 100. This isolation will help to prevent further damage and allow for a controlled shutdown of the affected servers or IT assets. Additionally, in some embodiments, the control unit 112 is capable of communicating these issues to other equipment (e.g., CDU, rPDU, BMS, etc.). This ensures that the broader management systems are informed and can take corrective actions, such as initiating a graceful shutdown of power or isolating entire racks or rows, to protect the integrity of electronic equipment and a data center.

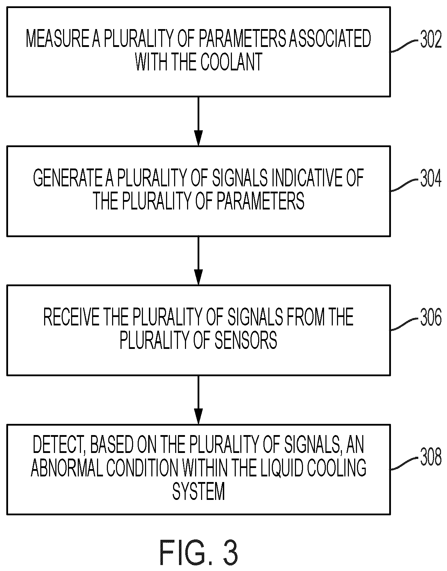

FIG. 3 depicts a flowchart 300 of a method for detection of an abnormal condition within an in-rack liquid cooling system, according to an example embodiment. As shown in FIG. 3, the method of flowchart 300 begins at step 302. In step 302, a plurality of parameters associated with the coolant is measured.

At step 304 in flowchart 300, a plurality of signals indicative of the plurality of parameters is generated.

At step 306 in flowchart 300, the plurality of signals from the plurality of sensors is received.

At step 308 in flowchart 300, based on the plurality of signals, an abnormal condition within the liquid cooling system is detected.

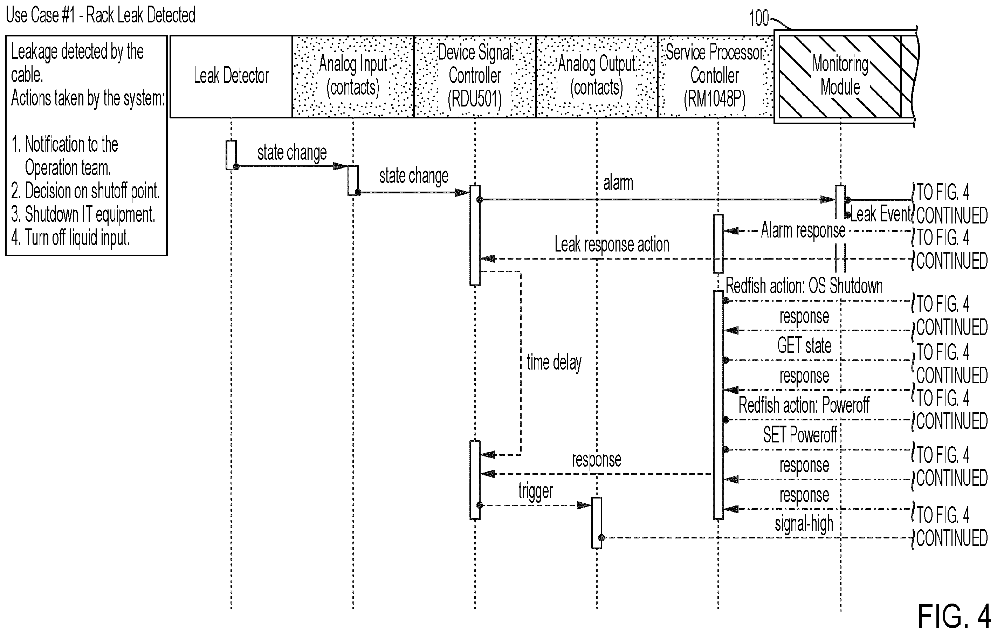

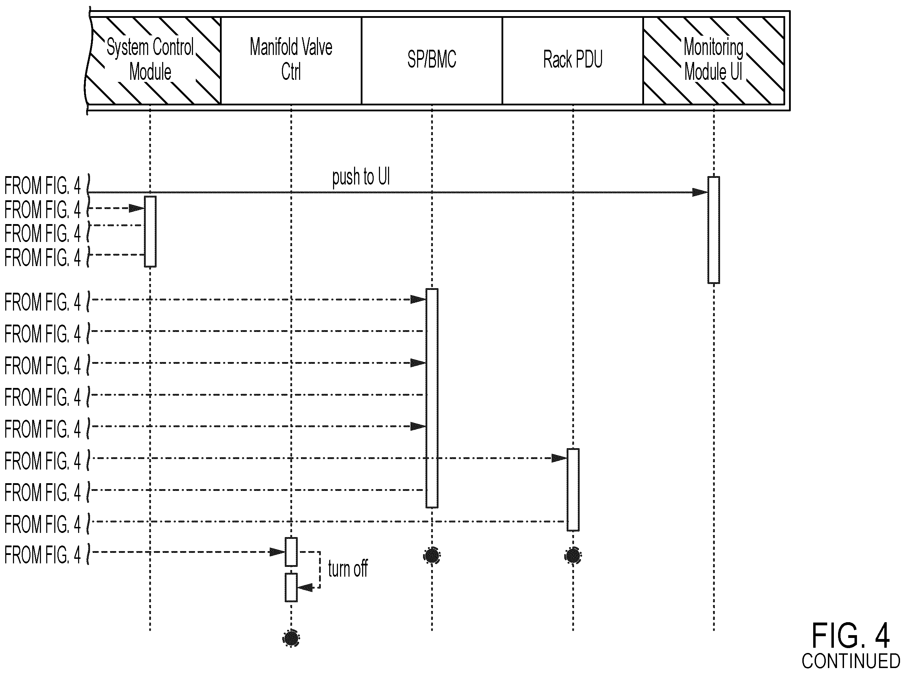

FIG. 4 depicts a use case of the liquid cooling system for detecting a rack leak. More specifically, FIG. 4 outlines the response actions taken by the liquid cooling system 100 when a coolant leak is detected. The liquid cooling system 100 may initiate a sequence of actions to address the leak. These actions may include notifying an operations team, determining a shutoff point, shutting down impacted equipment, and turning off a liquid input. This response ensures that the system can contain the issue quickly while minimizing damage to the equipment.

The diagram illustrates the flow of these actions through various modules of the liquid cooling system 100. After the leak is detected, an alarm is triggered, and the liquid cooling system 100 proceeds to notify an operations team. The liquid cooling system 100 then follows a sequence of commands, which include shutting down the operating system of the impacted equipment (e.g., using Redfish protocols, sending state and power-off commands) and ultimately turning off the liquid input to the in-rack manifold 102.

In some embodiments, the monitoring module and the system control module may work together as part of the control unit 112 to continuously assess data from sensors within the liquid cooling system 100. When an abnormal condition is detected by the monitoring module, the system control module may initiate the appropriate actions, coordinating responses across components, including triggering alarms and shutting off valves.

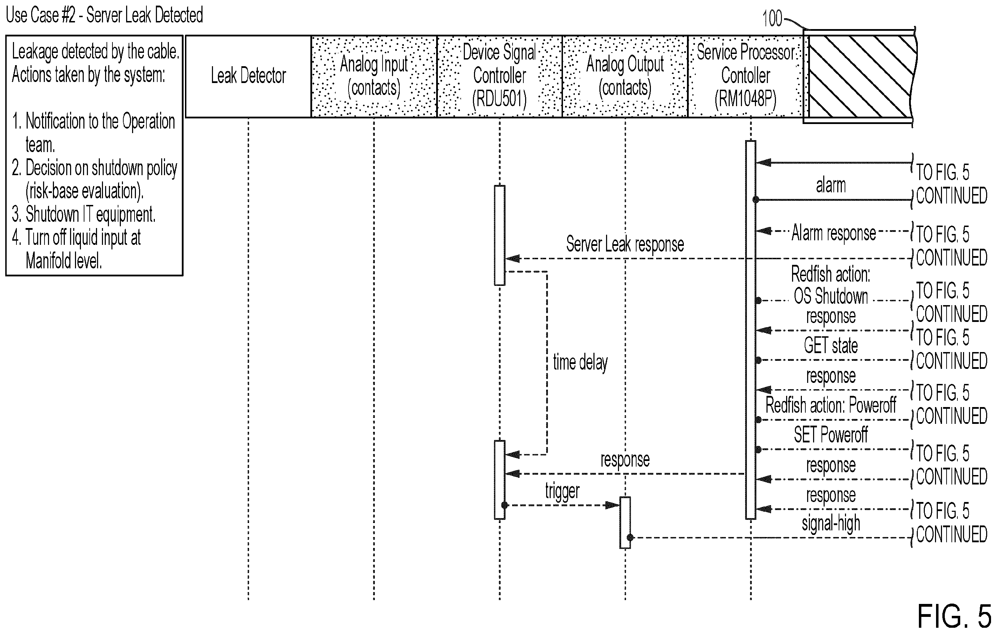

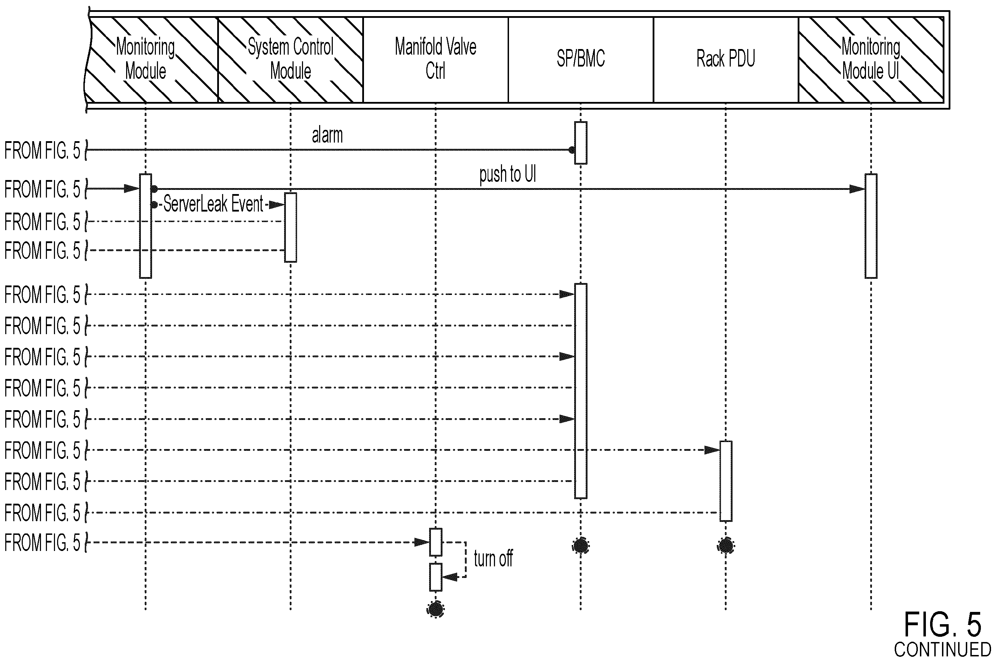

FIG. 5 depicts a use case of the liquid cooling system for detecting a server leak. More specifically, FIG. 5 illustrates the response sequence of the liquid cooling system 100 when a leak is detected. Upon detecting leakage event, the liquid cooling system 100 initiates a series of actions aimed at protecting IT equipment. For example, these actions may include notifying an operations team, performing a risk-based evaluation to determine the appropriate shutdown policy, shutting down IT equipment, and turning off liquid input at the manifold level. This helps isolate the affected section of the cooling loop, stopping the flow of coolant to prevent further leakage.

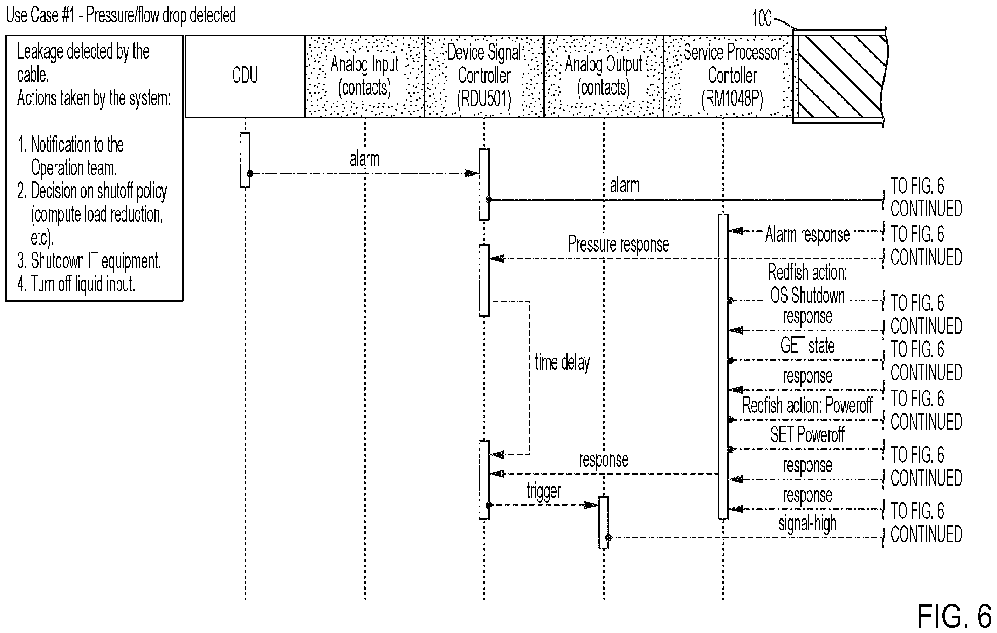

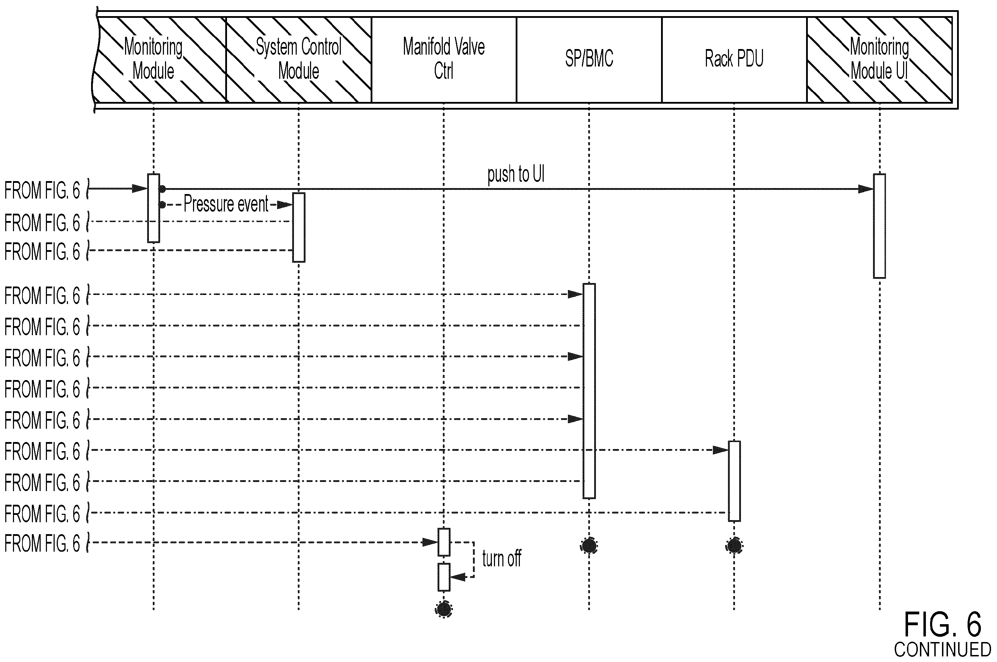

FIG. 6 depicts the response of the liquid cooling system 100 to a drop in pressure or flow within the liquid cooling system 100. When the liquid cooling system 100 detects a significant reduction in pressure or coolant flow, the liquid cooling system 100 follows a series of action to protect electronic equipment and prevent further damage. These actions include notifying the operations teams. This is followed by a decision on the appropriate shutdown policy, which may involve reducing the compute load, shutting down affected IT equipment, and turning off liquid input, stopping the of coolant to the affected areas.

FIG. 6 further shows how these actions flow through different modules of the liquid cooling system 100, such as the monitoring module, the system control module, and the manifold valve control.

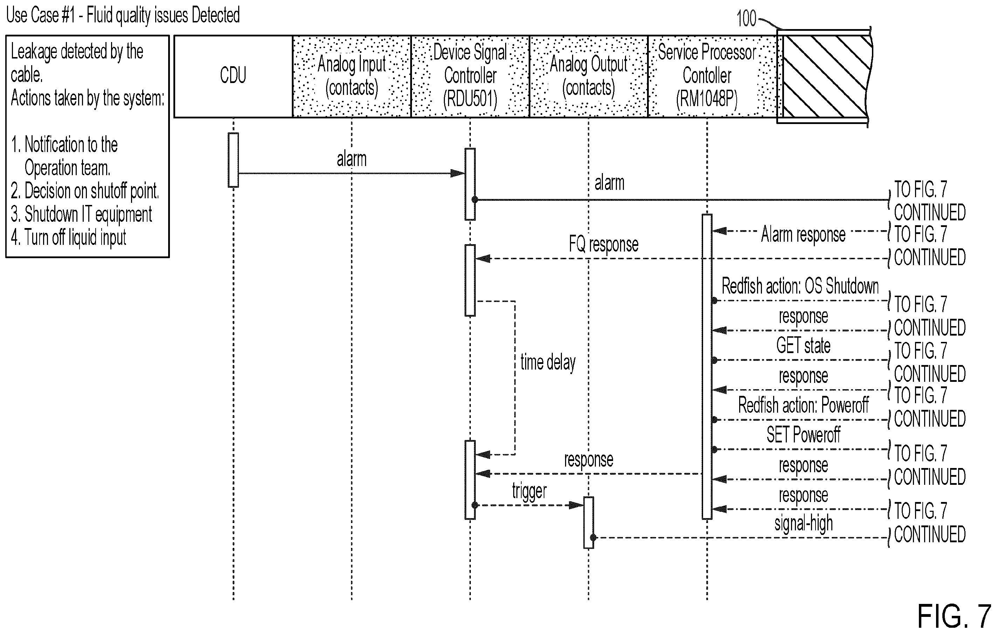

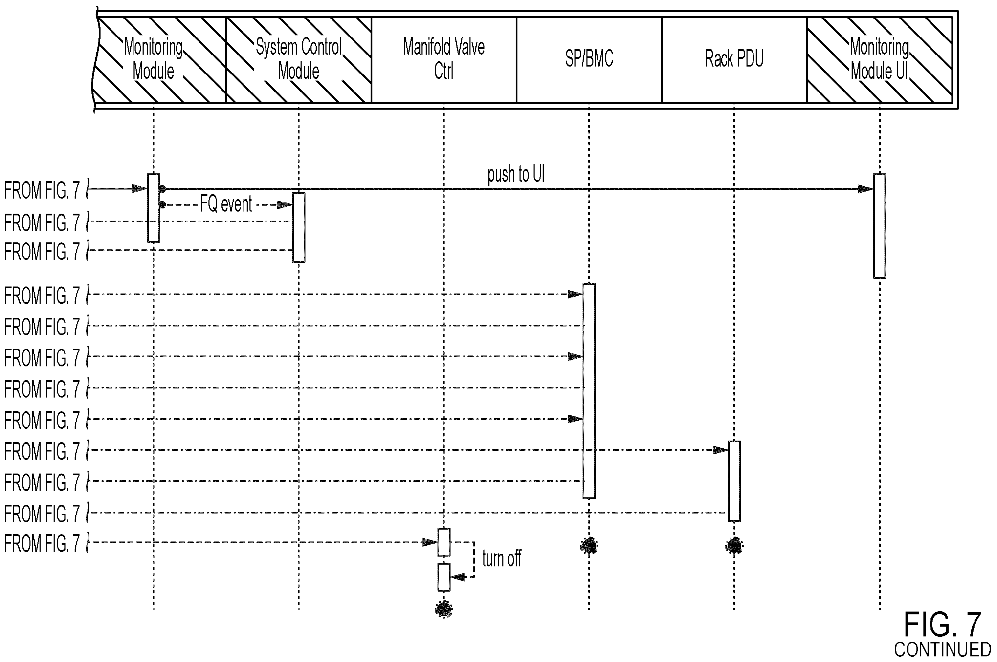

FIG. 7 depicts the response of the liquid cooling system 100 to detecting fluid quality issues within the liquid cooling system 100. When the system identifies an anomaly in the coolant-such as contamination or a change in coolant properties-the liquid cooling system 100 triggers a sequence of actions to mitigate potential risks to electronic equipment. The first step is to notify the operations team. Following this, a decision is on the appropriate shutdown point. Next, the liquid cooling system 100 moves to shut down the affected electronic equipment, and finally, the liquid input is turned off to stop the flow of compromised coolant into the liquid cooling system 100. FIG. 7 further shows how these actions are carried out across various system components, including the monitoring module, the system control module, and the manifold valve control.

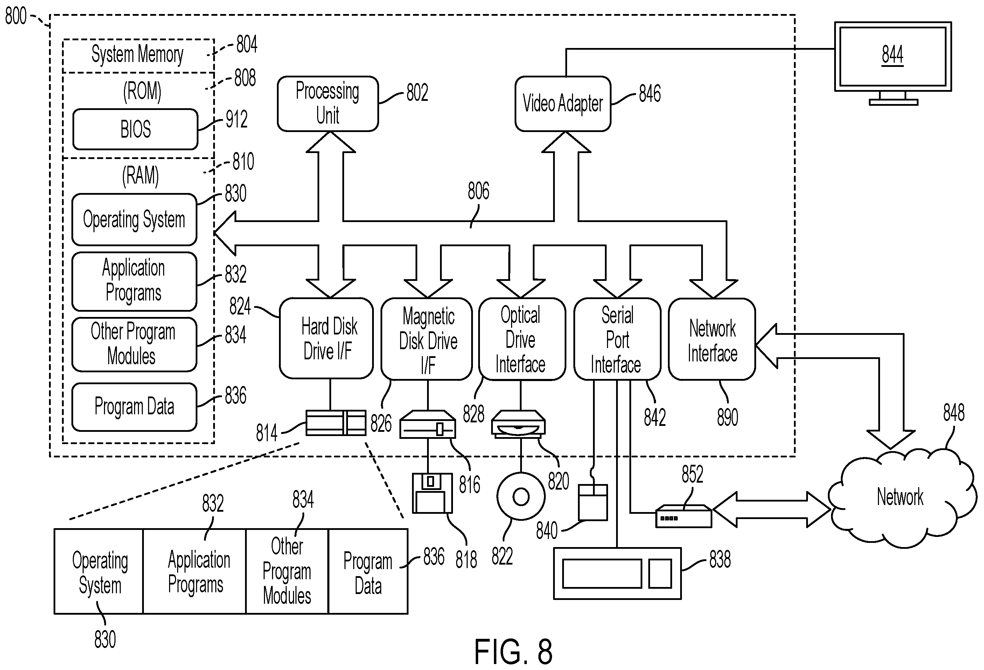

FIG. 8 depicts an example processor-based computer system 800 that may be used to implement various embodiments described herein, such as any of the embodiments described in the above and in reference to FIGS. 1-7. For example, processor-based computer system 800 may be used to implement any of the components of the liquid cooling system 100 as described above in reference to FIGS. 1-7. The description of processor-based computer system 800 provided herein is provided for purposes of illustration and is not intended to be limiting. Embodiments may be implemented in further types of computer systems, as would be known to persons skilled in the relevant art(s).

As shown in FIG. 8, processor-based computer system 800 includes one or more processors, referred to as processor circuit 802, a system memory 804, and a bus 806 that couples various system components including system memory 804 to processor circuit 802. Processor circuit 802 is an electrical and/or optical circuit implemented in one or more physical hardware electrical circuit device elements and/or integrated circuit devices (semiconductor material chips or dies) as a central processing unit (CPU), a microcontroller, a microprocessor, and/or other physical hardware processor circuit. Processor circuit 802 may execute program code stored in a computer readable medium, such as program code of operating system 830, application programs 832, other programs 834, etc. Bus 806 represents one or more of any of several types of bus structures, including a memory bus or memory controller, a peripheral bus, an accelerated graphics port, and a processor or local bus using any of a variety of bus architectures. System memory 804 includes read only memory (ROM) 808 and random access memory (RAM) 810. A basic input/output system 812 (BIOS) is stored in ROM 808.

Processor-based computer system 800 also has one or more of the following drives: a hard disk drive 814 for reading from and writing to a hard disk, a magnetic disk drive 816 for reading from or writing to a removable magnetic disk 818, and an optical disk drive 820 for reading from or writing to a removable optical disk 822 such as a CD ROM, DVD ROM, or other optical media. Hard disk drive 814, magnetic disk drive 816, and optical disk drive 820 are connected to bus 806 by a hard disk drive interface 824, a magnetic disk drive interface 826, and an optical drive interface 828, respectively. The drives and their associated computer-readable media provide nonvolatile storage of computer-readable instructions, data structures, program modules and other data for the computer. Although a hard disk, a removable magnetic disk and a removable optical disk are described, other types of hardware-based computer-readable storage media can be used to store data, such as flash memory cards, digital video disks, RAMs, ROMs, and other hardware storage media.

A number of program modules may be stored on the hard disk, magnetic disk, optical disk, ROM, or RAM. These programs include operating system 830, one or more application programs 832, other programs 834, and program data 836. Application programs 832 or other programs 834 may include, for example, computer program logic (e.g., computer program code or instructions) for implementing the systems described above, including the embodiments described in reference to FIGS. 1-7.

A user may enter commands and information into processor-based computer system 800 through input devices such as keyboard 838 and pointing device 840. Other input devices (not shown) may include a microphone, joystick, game pad, satellite dish, scanner, a touch screen and/or touch pad, a voice recognition system to receive voice input, a gesture recognition system to receive gesture input, or the like. These and other input devices are often connected to processor circuit 802 through a serial port interface 842 that is coupled to bus 806, but may be connected by other interfaces, such as a parallel port, game port, or a universal serial bus (USB).

A display screen 844 is also connected to bus 806 via an interface, such as a video adapter 846. Display screen 844 may be external to, or incorporated in processor-based computer system 800. Display screen 844 may display information, as well as being a user interface for receiving user commands and/or other information (e.g., by touch, finger gestures, virtual keyboard, etc.). In addition to display screen 844, processor-based computer system 800 may include other peripheral output devices (not shown) such as speakers and printers.

Processor-based computer system 800 is connected to a network 848 (e.g., the Internet) through an adaptor or network interface 850, a modem 852, or other means for establishing communications over the network. Modem 852, which may be internal or external, may be connected to bus 806 via serial port interface 842, as shown in FIG.8, or may be connected to bus 806 using another interface type, including a parallel interface.

As used herein, the terms "computer program medium," "computer-readable medium," and "computer-readable storage medium" are used to generally refer to physical hardware media such as the hard disk associated with hard disk drive 814, removable magnetic disk 818, removable optical disk 822, other physical hardware media such as RAMs, ROMs, flash memory cards, digital video disks, zip disks, MEMs, nanotechnology-based storage devices, and further types of physical/tangible hardware storage media (including system memory 804 of FIG. 8). Such computer-readable storage media are distinguished from and non-overlapping with communication media (do not include communication media). Communication media typically embodies computer-readable instructions, data structures, program modules or other data in a modulated data signal such as a carrier wave. The term "modulated data signal" means a signal that has one or more of its characteristics set or changed in such a manner as to encode information in the signal. By way of example, and not limitation, communication media includes wireless media such as acoustic, RF, infrared and other wireless media, as well as wired media. Embodiments are also directed to such communication media.

As noted above, computer programs and modules (including application programs 832 and other programs 834) may be stored on the hard disk, magnetic disk, optical disk, ROM, RAM, or other hardware storage medium. Such computer programs may also be received via network interface 850, serial port interface 842, or any other interface type. Such computer programs, when executed or loaded by an application, enable processor-based computer system 800 to implement features of embodiments discussed herein. Accordingly, such computer programs represent controllers of processor-based computer system 800.

In some embodiments, a liquid cooling system includes an in-rack manifold configured to circulate coolant to in-rack electronic components. The in-rack manifold comprising a plurality of sensors positioned within the in-rack manifold, the plurality of sensors configured to: measure a plurality of parameters associated with the coolant; and generate a plurality of signals indicative of the plurality of parameters. The system also includes a control unit configured to: receive the plurality of signals from the plurality of sensors; and detect, based on the plurality of signals, an abnormal condition within the liquid cooling system.

In some embodiments, the plurality of parameters includes at least one of a capacity parameter, a volume parameter, a temperature parameter, and a quality parameter. In some embodiments, the abnormal condition indicates at least one of a leak, a blockage, an equipment malfunction, and insufficient cooling. In some embodiments, the control unit is further configured to: in response to detecting the abnormal condition, initiate a corrective action to address a problem with the liquid cooling system indicated by the abnormal condition. In some embodiments, the in-rack manifold further includes a plurality of valves positioned within the in-rack manifold. In some embodiments, the corrective action includes adjusting a set of valves of the plurality of valves. In some embodiments, the corrective action includes initiating an alarm. In some embodiments, the alarm is configured to indicate the problem with the liquid cooling system indicated by the abnormal condition. In some embodiments, the corrective action includes sending a notification of the abnormal condition.

In some embodiments, a method includes: measuring a plurality of parameters associated with a liquid coolant of a liquid coolant system; generating a plurality of signals indicative of the plurality of parameters; receiving the plurality of signals; and detecting, based on the plurality of signals, an abnormal condition within the liquid cooling system.

In some embodiments, the plurality of parameters includes at least one of a capacity parameter, a volume parameter, a temperature parameter, and a quality parameter. In some embodiments, the abnormal condition indicates at least one of a leak, a blockage, an equipment malfunction, and insufficient cooling. In some embodiments, the method also includes, in response to detecting the abnormal condition, initiating a corrective action to address a problem with the liquid cooling system indicated by the abnormal condition. In some embodiments, the liquid cooling system includes an in-rack manifold. In some embodiments, the in-rack manifold includes a plurality of valves positioned within the in-rack manifold. In some embodiments, corrective action includes adjusting at least one value of the plurality of valves. In some embodiments, the corrective action includes initiating an alarm. In some embodiments, the alarm is configured to indicate the problem with the liquid cooling system indicated by the abnormal condition. In some embodiments, the corrective action includes sending a notification of the abnormal condition.

In some embodiments, an apparatus includes a computing device configured to: measure, using a plurality of sensors associated with an in-rack manifold, a plurality of parameters associated with a liquid coolant of a liquid cooling system; generate a plurality of signals indicative of the plurality of parameters; and detect, based on the plurality of signals, an abnormal condition within the liquid cooling system.

Implementations of the systems, algorithms, methods, instructions, etc., described herein can be realized in hardware, software, or any combination thereof. The hardware can include, for example, computers, intellectual property (IP) cores, application-specific integrated circuits (ASICs), programmable logic arrays, optical processors, programmable logic controllers, microcode, microcontrollers, servers, microprocessors, digital signal processors, or any other suitable circuit. In the claims, the term "processor" should be understood as encompassing any of the foregoing hardware, either singly or in combination. The terms "signal" and "data" are used interchangeably.

As used herein, the term module can include a packaged functional hardware unit designed for use with other components, a set of instructions executable by a controller (e.g., a processor executing software or firmware), processing circuitry configured to perform a particular function, and a self-contained hardware or software component that interfaces with a larger system. For example, a module can include an application specific integrated circuit (ASIC), a Field Programmable Gate Array (FPGA), a circuit, digital logic circuit, an analog circuit, a combination of discrete circuits, gates, and other types of hardware or combination thereof. In other embodiments, a module can include memory that stores instructions executable by a controller to implement a feature of the module.

Further, in one aspect, for example, systems described herein can be implemented using a general-purpose computer or general-purpose processor with a computer program that, when executed, carries out any of the respective methods, algorithms, and/or instructions described herein. In addition, or alternatively, for example, a special purpose computer/processor can be utilized which can contain other hardware for carrying out any of the methods, algorithms, or instructions described herein.

Further, all or a portion of implementations of the present disclosure can take the form of a computer program product accessible from, for example, a computer-usable or computer-readable medium. A computer-usable or computer-readable medium can be any device that can, for example, tangibly contain, store, communicate, or transport the program for use by or in connection with any processor. The medium can be, for example, an electronic, magnetic, optical, electromagnetic, or a semiconductor device. Other suitable mediums are also available.

The above-described embodiments, implementations, and aspects have been described in order to allow easy understanding of the present disclosure and do not limit the present disclosure. On the contrary, the disclosure is intended to cover various modifications and arrangements included within the scope of the appended claims, which scope is to be accorded the broadest interpretation to encompass all such modifications as is permitted under the law.

## Claims

1. A liquid cooling system, comprising:
an in-rack manifold configured to circulate coolant to in-rack electronic components, the in-rack manifold comprising a plurality of sensors positioned within the in-rack manifold, the plurality of sensors configured to:
measure a plurality of parameters associated with the coolant; and
generate a plurality of signals indicative of the plurality of parameters; and
a control unit configured to:
receive the plurality of signals from the plurality of sensors; and
detect, based on the plurality of signals, an abnormal condition within the liquid cooling system.

2. The liquid cooling system of claim 1, wherein the plurality of parameters includes at least one of a capacity parameter, a volume parameter, a temperature parameter, and a quality parameter.

3. The liquid cooling system of claim 1 or 2, wherein the abnormal condition indicates at least one of a leak, a blockage, an equipment malfunction, and insufficient cooling.

4. The liquid cooling system of any preceding claim, wherein the control unit is further configured to:
in response to detecting the abnormal condition, initiate a corrective action to address a problem with the liquid cooling system indicated by the abnormal condition.

5. The liquid cooling system of claim 4, wherein the in-rack manifold further includes a plurality of valves positioned within the in-rack manifold, and optionally wherein the corrective action includes adjusting a set of valves of the plurality of valves.

6. The liquid cooling system of claim 5, wherein the corrective action includes initiating an alarm, and optionally wherein the alarm is configured to indicate the problem with the liquid cooling system indicated by the abnormal condition.

7. The liquid cooling system of claim 5 or 6, wherein the corrective action includes sending a notification of the abnormal condition.

8. A method comprising:
measuring a plurality of parameters associated with a liquid coolant of a liquid coolant system;
generating a plurality of signals indicative of the plurality of parameters;
receiving the plurality of signals; and
detecting, based on the plurality of signals, an abnormal condition within the liquid cooling system.

9. The method of claim 8, wherein the plurality of parameters includes at least one of a capacity parameter, a volume parameter, a temperature parameter, and a quality parameter.

10. The method of claim 8 or 9, wherein the abnormal condition indicates at least one of a leak, a blockage, an equipment malfunction, and insufficient cooling.

11. The method of any of claims 8 to 10, further comprising, in response to detecting the abnormal condition, initiating a corrective action to address a problem with the liquid cooling system indicated by the abnormal condition.

12. The method of claim 11, wherein the liquid cooling system includes an in-rack manifold.

13. The method of claim 12, wherein the in-rack manifold includes a plurality of valves positioned within the in-rack manifold, and optionally wherein the corrective action includes adjusting at least one value of the plurality of valves.

14. The method of claim 13, wherein the corrective action includes initiating an alarm, optionally wherein the alarm is configured to indicate the problem with the liquid cooling system indicated by the abnormal condition, and/or wherein the corrective action includes sending a notification of the abnormal condition.

15. An apparatus comprising:
a computing device configured to:
measure, using a plurality of sensors associated with an in-rack manifold, a plurality of parameters associated with a liquid coolant of a liquid cooling system;
generate a plurality of signals indicative of the plurality of parameters; and
detect, based on the plurality of signals, an abnormal condition within the liquid cooling system.
